# EUROPEAN PATENT SPECIFICATION

(11) **EP 4 246 106 B1**
(45) Date of publication and mention of the grant of the patent: **23.07.2025**
(21) Application number: 23158244.6
(22) Date of filing: 23.02.2023
(51) Int. Cl.: G01H 11/06, G06V 40/13

(54) **INTEGRATED PIEZORESITIVE (PZR) AND PIEZOELECTRIC MICROMACHINED ULTRASONIC TRANSDUCER (PMUT) DEVICE AND RELATED HIGH-VOLTAGE (HV) / BIPOLAR-CMOS-DMOS (BCD) PROCESSING METHODS**
INTEGRIERTE PIEZORESISTIVE (PZR) UND PIEZOELEKTRISCHE MIKROBEARBEITETE ULTRASCHALLWANDLER (PMUT) UND ZUGEHÖRIGE HOCHSPANNUNGS (HV) / BIPOLAR-CMOS-DMOS (BCD)-VERARBEITUNGSVERFAHREN
DISPOSITIF À TRANSDUCTEUR ULTRASONORE PIÉZOÉLECTRIQUE MICRO-USINÉ (PMUT) ET PIÉZOÉLECTRIQUE INTÉGRÉ PIÉZO-RÉSISTIF (PZR) ET MÉTHODES RELIÉES DE CALCUL HAUTE TENSION/BIPOLAIRE-CMOS-DMOS

(30) Priority: 24.02.2022 US 202263313455 P; 09.02.2023 US 202318107642
(43) Date of publication of application: 20.09.2023
(73) Proprietor: Qorvo US, Inc., Greensboro, NC 27409 (US)
(72) Inventor: TSAI, Julius Minglin, Mountain View 94043 (US); BENJAMIN, Daniel Krstyen, Greenboro 27409 (US); CHEN, Yenhao, Mountain View 94043 (US); KWA, Tom A., Mountain View 94043 (US)
(74) Representative: D Young & Co LLP

(56) References cited:
- WO-A1-2021/033030
- WO-A1-2022/026046
- CN-A- 110 560 350
- CN-A- 112 871 612
- US-A1- 2006 004 290
- US-A1- 2015 357 375
- US-A1- 2016 041 047
- US-A1- 2019 141 456
- US-A1- 2019 354 238
- US-A1- 2020 257 875
- US-A1- 2020 357 379
- US-A1- 2021 286 060
- US-A1- 2021 293 648
- US-A1- 2021 401 404
- US-B2- 10 573 289

## Description

### BACKGROUND

The present disclosure relates generally to sensors for detecting user interactions on human-machine interfaces (HMIs) and, more specifically, to a hybrid sensing device having integrated piezoresistive (PZR) and piezoelectric micromachined ultrasonic transducer (PMUT) elements for measuring multiple physical parameters associated with a user interaction (e.g., touch).

Capacitive touch sensing has become an increasingly common method of receiving user inputs to an HMI. Over time, industrial design innovations have proliferated into seamless touch surfaces for devices such as smartphones, smartwatches, automotive steering wheels and dashboards, headphones, and the like. In these and other types of devices, traditional mechanical buttons may be replaced with seamless touch surfaces for receiving user inputs to control said devices. For example, traditional mechanical buttons may be replaced with virtual buttons displayed on an HMI. However, commonly used capacitive touch sensing sensors and methods are often incapable of sensing and/or interpreting a level of force applied (e.g., which may be indicative of intent) by a user input (e.g., a touch on an HMI). Additionally, force sensors may sense and/or interpret the level of an applied force by a user on an HMI but may not accurately determine the location of the touch. In instances where a user applies a significant amount of force (e.g., over a threshold level), for example, these typical force sensors may trigger a false positive by registering a touch on an incorrect area of the HMI.
WO 2022/026046 A1 discusses a method which may involve estimating a force applied by a target object on a surface, determining at least one ultrasonic fingerprint sensor parameter modification based, at least in part, on the force and updating at least one setting of an ultrasonic fingerprint sensor based, at least in part, on the ultrasonic fingerprint sensor parameter modification. The method may involve controlling the ultrasonic fingerprint sensor to transmit first and second ultrasonic waves towards the target object and receiving first and second ultrasonic receiver signals, including signals corresponding to reflections of the first and second ultrasonic waves from the target object, from the ultrasonic fingerprint sensor. The method may involve performing an authentication process based, at least in part, on the first and second ultrasonic receiver signals.
WO 2021/033030 A1 discusses a frequency-tunable ultrasonic device.
US 2020/0357379 A1 discusses transmit beamforming of a two-dimensional array of ultrasonic transducers.
CN 110 560 350 A discusses an ultrasonic receiving transducer based on Helmholtz resonant cavity.
US 2016/041047 A1 discusses a piezoelectric acoustic resonator based sensor.
US 2019/354238 A1 discusses ultrasonic touch detection and decision.
US 2015/357375 A1 discusses an integrated piezoelectric microelectromechanical ultrasound transducer (PMUT) on integrated circuit (IC) for fingerprint sensing.
CN 112 871 612 A discusses a piezoelectric micro mechanical ultrasonic transducer with multiple piezoelectric layers.
US 2019/141456 A1 discusses piezoelectric package-integrated acoustic transducer devices.
However, none of these documents disclose at least the following features of appended claim 1: wherein the piezoresistive element is implanted into a surface of the substrate, and wherein the PMUT is layered over the surface of the substrate.

### SUMMARY

Particular aspects are set out in the appended independent claims. Various optional embodiments are set out in the dependent claims.

One implementation of the present disclosure is a hybrid sensor that includes a piezoresistive element for sensing an applied force, a piezoelectric micromachined ultrasonic transducer (PMUT) for sensing the presence of an object within a threshold distance of the hybrid sensor, and a substrate onto which both the piezoresistive element and the PMUT are disposed.

In some embodiments, the PMUT is configured to transmit and receive ultrasonic pressure waves to sense the presence of an object.

In some embodiments, the ultrasonic pressure waves are in the range of 100 kHz to 100 MHz.

According to the invention, the piezoresistive element is implanted into a surface of the substrate and the PMUT is layered over the surface of the substrate.

In some embodiments, the PMUT includes a piezoelectric layer disposed between a bottom electrode and a top electrode, and a resonator cavity disposed below the bottom electrode.

In some embodiments, the resonator cavity is a sealed cavity.

In some embodiments, the piezoelectric layer is made of aluminum nitride (AlN) or scandium-doped aluminum nitride (AlScN).

In some embodiments, the bottom electrode includes molybdenum (Mo).

In some embodiments, the hybrid sensor further includes processing circuitry configured to process respective electrical signals output from each of the piezoresistive element and the PMUT.

In some embodiments, the respective electrical signal output from the piezoresistive element is responsive to the applied force.

In some embodiments, the respective electrical signal output from the PMUT is responsive to the presence of the object within the threshold distance of the hybrid sensor.

In some embodiments, the processing circuitry is configured to process the respective electrical signals by comparing the respective electrical signals to respective thresholds to determine whether a touch event is classified as a true touch event or a false touch event.

In some embodiments, the touch event is classified as the true touch event when each of the respective electrical signals exceeds the respective threshold, and the touch event is classified as the false touch event when only one of the respective electrical signals exceeds the respective threshold.

In some embodiments, the processing circuitry includes at least one of a complementary metal-oxide-semiconductor (CMOS), a double-diffused metal-oxide semiconductor field-effect transistor (DMOS), or a bi-polar junction transistor (BJT).

In some embodiments, the processing circuitry is further configured to apply a plurality of high-voltage pulses to the PMUT to cause the PMUT to transmit ultrasonic pressure waves.

In some embodiments, the processing circuity is disposed on the substrate.

In some embodiments, the hybrid sensor is implemented in an open cavity molded package.

In some embodiments, the open cavity molded package includes a cavity disposed on top of the PMUT, the cavity filled with a medium that transmits ultrasonic pressure waves to the PMUT.

In some embodiments, the hybrid sensor is implemented in a back-side wafer level chip scale package (WLCSP).

In some embodiments, the hybrid sensor is implemented in a standard wafer level chip scale package (WLCSP).

### BRIEF DESCRIPTION OF THE DRAWINGS

Various objects, aspects, features, and advantages of the disclosure will become more apparent and better understood by referring to the detailed description taken in conjunction with the accompanying drawings, in which like reference characters identify corresponding elements throughout. In the drawings, like reference numbers generally indicate identical, functionally similar, and/or structurally similar elements.
FIG. 1 is a cross-sectional diagram of a hybrid sensor having integrated piezoresistive (PZR) and piezoelectric micromachined ultrasonic transducer (PMUT) elements with a bipolar-CMOS-DMOS (BCD) process layer, according to some embodiments.
FIG. 2 is a cross-sectional diagram of an alternate configuration of the hybrid sensor of FIG. 1 having a high-voltage (HV) process layer, according to some embodiments.
FIG. 3 is a diagram of a PZR implant process, according to some embodiments.
FIG. 4 is a diagram illustrating an example CMOS process, according to some embodiments.
FIG. 5 is a diagram illustrating an example HV/BDC process, according to some embodiments.
FIGS. 6A and 6B are diagrams illustrating a configuration of the integrated PZR and PMUT device of FIGS. 1 and/or 2 in an open cavity molded package, according to some embodiments.
FIGS. 7A and 7B are diagrams illustrating an alternate configuration of the integrated PZR and PMUT device of FIGS. 1 and/or 2 in an open cavity molded package, according to some embodiments.
FIGS. 8A and 8B are diagrams illustrating a configuration of the integrated PZR and PMUT device of FIGS. 1 and/or 2 in a back-side wafer-level chip-scale package (WLCSP), according to some embodiments.
FIGS. 9A-9C are diagrams illustrating a configuration of the integrated PZR and PMUT device of FIGS. 1 and/or 2 in a standard WLSCP, according to some embodiments.

### DETAILED DESCRIPTION

Referring generally to the FIGURES, a hybrid sensing device is shown, according to various embodiments. In particular, the hybrid sensing device described herein includes both piezoresistive (PZR) and piezoelectric micromachined ultrasonic transducer (PMUT) elements that are integrated into a single wafer. The PZR element(s) of the hybrid sensor are configured to sense an amount of force applied either directly or indirectly to the sensor and the PMUT element(s) are configured to transmit and/or received ultrasonic pressure waves for detecting the presence of an object (e.g., a user's finger) in proximity to the sensor. The hybrid sensor can also include additional processing circuitry for interpreting electrical signals from the PZR and PMUT elements. By comparing the responses of the PZR and PMUT elements, a determination can be made whether a detected touch event is a "true touch event" or a "false touch event." For example, if the PZR element of the sensor detects an applied force but the PMUT element does not detect an object, the corresponding event may be identified as a "false touch event."

In this manner, the hybrid sensor described herein may address many of the shortcomings described above with respect to more traditional capacitive and force sensors. For example, the rate of false positives due to extremely small input (e.g., touch) forces may be mitigated by validating a sensed force using the second sensing element. Furthermore, unlike many other types of capacitive and/or force sensors, the PZR, PMUT, and processing elements described herein may be integrated into a single chip (e.g., silicon chip), which provides improved sensing capabilities over other devices in a small, energy efficient package. As described in greater detail below, these hybrid sensors may also be manufactured for a low cost in various packaging formats, such as an open cavity molded package or a wafer level chip scale package (WLCSP), which can lower the threshold for technology proliferation. Accordingly, the hybrid sensor described herein may be a low-cost and easily-implemented replacement for mechanical button and other sensing devices in a variety of materials and surfaces. Additional features and advantages are described in greater detail below.

### Hybrid Sensor

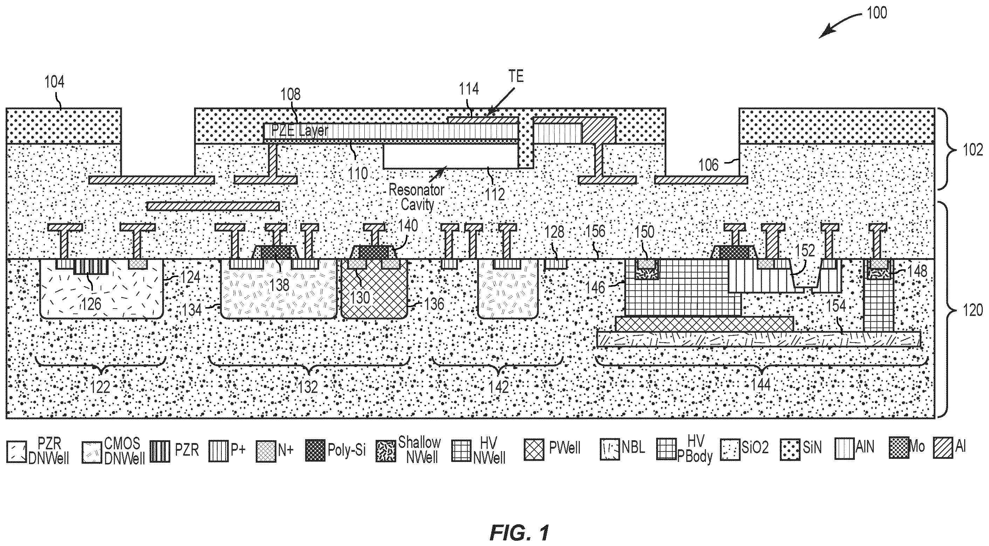

Referring to FIG. 1, a cross-sectional diagram of a hybrid sensor 100 having integrated PZR and PMUT elements with a bipolar-CMOS-DMOS (BCD) process layer 120 is shown, according to some embodiments. Specifically, the PMUT element of hybrid sensor 100 is shown as a PMUT layer 102 disposed (i.e., layered) on top of the BCD process layer 120. The PMUT layer 102 is formed from the lower part of a silicon dioxide (SiO₂) layer 106 and a semiconductor substrate 156. The SiO₂ layer 106 is formed over a surface of the semiconductor substrate 156. As briefly mentioned above, the PMUT layer 102 may be configured to detect the presence of an object, such as a user's finger, in proximity to the hybrid sensor 100. To do so, the PMUT layer 102 generates and transmits ultrasonic pressure waves that are broadcast into a surrounding medium (e.g., air, water, etc.) and, when an ultrasonic pressure wave hits an object (e.g., the user's finger), the wave is reflected back towards the PMUT layer 102, where it is received.

In some embodiments, the PMUT layer 102 transmits ultrasonic pressure waves by applying voltage pulses (e.g., high voltage pulses) to at least one of a bottom electrode 110 or a top electrode 114, which are disposed on respective bottom and top sides of a piezoelectric (PZE) layer 108. As shown, the PZE layer 108 may be formed of aluminum nitride (AlN) disposed on a silicon nitride (SiN) layer 104. In FIG. 1, the PZE layer 108 is embedded in the SiN layer 104. The PMUT layer 102 includes the SiN layer 104 and a top portion of the SiO₂ layer 106. The bottom electrode 110 is formed directly on a resonator cavity 112 and the top surface of the SiNlayer 104. While shown as a single layer of SiN, in some embodiments, the SiN layer 104 is formed of stacked silicon oxide and silicon nitride layers. The bottom electrode 110 may be formed of molybdenum (Mo) and/or aluminum (Al) having an Mo layer, to enhance the crystal structure of the PZE layer 108, and the top electrode 114 may be formed of Al; however, it will be appreciated that other materials and/or element for forming these and other components of the hybrid sensor 100 are contemplated herein. In various embodiments, for example, the PZE layer 108 may be formed of scandium-doped aluminum nitride (AlScN) or another suitable PZE material. Additionally, various traces or electrodes formed of Al are shown throughout the hybrid sensor 100; however, for clarity and conciseness, not every trace or electrode is identified independently.

Positioned beneath the bottom electrode 110 is the resonator cavity 112 which can be used to tune the transmission (Tx) and receiving (Rx) frequencies of the PMUT layer 102. In particular, the geometric dimensions of the resonator cavity 112 may be selected based on a desired range of Tx and Rx frequencies. In some embodiments, the resonator cavity 112 is sized such that the PMUT layer 102 transmits and receives frequencies ranging from 100 kHz to 100 MHz. In some embodiments, the resonator cavity 112 is sized such that the PMUT layer 102 transmits and receives frequencies above 10 MHz, although typically less than 100 MHz. In some embodiments, the geometric dimensions of the PZE layer 108, the bottom electrode 110, and the top electrode 114 are also selected to tune the Tx and Rx frequencies of the PMUT layer 102.

In some embodiments, the SiO₂ layer 106 defines a portion of both the PMUT layer 102 and the BCD layer 120. In some embodiments, the SiO₂ layer 106 electrically (i.e., via traces or electrodes formed in the SiO₂ layer) and/or mechanically couples various components of the PMUT layer 102 and the BCD layer 120. In some embodiments, various components of the BCD layer 120 may transmit and receive electrical signals to/from the PMUT layer 102 via metal electrodes disposed in the SiO₂ layer 106. As shown, for example, the BCD layer 120 can include one or more of a PZR sensor 122, a complementary metal-oxide-semiconductor (CMOS) element 132, a bi-polar junction transistor (BJT) 142, and a double-diffused metal-oxide semiconductor field-effect transistor (DMOS) element 144. The CMOS element 132, the BJT 142, and the DMOS element 144 are sometimes referred to herein as processing circuitry. The processing circuitry may independently drive the PMUT layer 102 to produce ultrasonic pressure waves and/or may process signals from the PMUT layer 102 due to sensed ultrasonic pressure waves, via the SiO₂ layer 106. Additionally, the processing circuity may process signals from the PZR sensor 122 due to sensed applied force. In some embodiments, the semiconductor substrate 156 is referred to as a (Si) layer 156 (e.g., the Si wafer).

As mentioned above, the PZR sensor 122 may be configured to sense an amount of force applied directly or indirectly to the hybrid sensor 100. Specifically, the PZR sensor 122 may experience a change in resistance due to an applied mechanical strain (e.g., from a user input). In some embodiments, the PZR sensor 122 is formed of a PZR deep N-well (DNWell) region 124 disposed in the Si layer 156 (e.g., the Si wafer) of the BCD layer 120. Disposed within the PZR DNWell region 124 is a piezoresistor (PZR) element 126, along with a P+ region 128 and an N+ region 150. As shown, for example, a first electrode may extend from the P+ region 128 into the SiO₂ layer 106 and a second electrode may extend from the N+ region 150 into the SiO₂ layer 106.

As described herein, the Si layer 156 may be the base layer or substrate onto which each of the PZR sensor 122, the CMOS element 132, the BJT 142, and the DMOS element 144 are integrated, and onto which the PMUT 102 is layered. In other words, all of the elements of the PMUT 102 and the BCD process layer 120 are disposed on a single substrate or wafer, unlike many other types of touch sensors that may have sensing and processing components disposed on multiple different substrates. Not only does this make the hybrid sensor 100 more compact than many other touch sensing devices but it can also simplify manufacturing, as discussed below.

Positioned next to the PZR sensor 122 and, in some embodiments also disposed in the Si layer 156, is the CMOS element 132. The CMOS element 132 is formed of a CMOS DNWell region 134 and a PWell region 136. Disposed within the CMOS DNWell region 134 are two P+ regions (e.g., two of the P+ region 128) coupled to corresponding electrodes that extend into the SiO₂ layer 106. Between these electrodes and over the CMOS DNWell region 134 is a polysilicon (poly-Si) region 138. The poly-Si region is encased by SiN and may form the gate of a field effect transistor (FET). As shown, a third electrode may extend from the poly-Si region 138 into the SiO₂ layer 106. The CMOS element 132 further includes the PWell region 136. Two N+ regions 130 are embedded in the PWell region 136. Positioned above the PWell region 136 and disposed within the SiO₂ layer 106 is a second poly-Si region 138 flanked by two SiN regions. The second poly-Si region 138 is embedded in SiN and forms the gate of a FET.

The BJT 142 includes three P+ regions 128, including one P+ region 128 disposed within a second CMOS DNWell region 134. Extending from two of P+ regions 128, including the P+ regions 128 disposed in the CMOS DNWell region 134, are separate electrodes. The DMOS element 144, shown next to the BJT 142 in the example of FIG. 1, includes a first HV NWell region 146 having a shallow NWell region 148 disposed therein, which further includes yet another N+ region 150. Beneath the HV NWell region 146 is a second PWell region 136 and, beneath PWell region 136, is a N-type buried layer (NBL) 154.

The DMOS element 144 also includes an HV PBody region 152 having two P+ regions 128 and the N+ region 150 disposed therein. In some embodiments, a well may be formed in the HV PBody region 152 which may be filled with SiO₂ from the SiO₂ layer 106. The DMOS element 144 is also shown to include the poly-Si region 138 flanked by two SiN regions 140. Electrodes are shown to extend from each of poly-Si region 138, P+ regions 128, and the N+ region 150. Further, a second HV NWell region 146 is shown having a second shallow NWell region 148 and another N+ region 150 disposed therein.

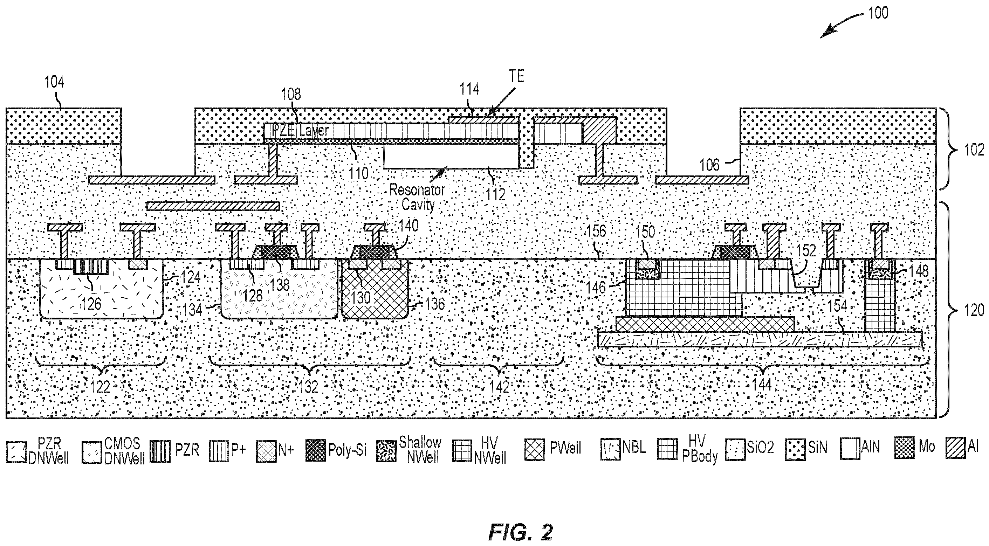

Referring now to FIG. 2, a cross-sectional diagram of an alternate configuration of the hybrid sensor 100 having a high-voltage (HV) process layer 160? Is shown, according to some embodiments. As shown, the alternate configuration of the hybrid sensor 100 is generally similar to the configuration of the hybrid sensor 100; however, unlike the BCD process layer 120, the HV process layer 160? does not include a BJT (e.g., the BJT 142). That said, in either configuration, the components of the BCD process layer 120 and the HV process layer 160? may be configured to drive the PMUT 102 to produce and sense ultrasonic pressure waves, and both include the PZR sensor 122 for sensing a force applied to the hybrid sensor 100. Further, both configurations include the CMOS element 132 and the DMOS element 144 which, in some embodiments, can convert the analog electrical signals from the PMUT layer 102 and/or the PZR sensor 122 into digital signals. Further, in some embodiments, the CMOS element 132 and/or the DMOS element 144 perform signal processing on the digital signals to evaluate a sensed touch.

As described briefly above, unlike many other types of force and/or touch sensors, the responses of the PZR sensor 122 and the PMUT layer 102 of the hybrid sensor 100 may be utilized in conjunction as a form of "voting system," to more accurately detect user inputs. Another type of hybrid sensor that includes a voting system similar to that of hybrid sensor is disclosed in PCT Patent App. No. PCT/US22/14519, filed January 31, 2022. For example, the PMUT layer 102 may detect the presence of an object, such as the user's finger, in proximity to the hybrid sensor 100, whereas PZR sensor 122 can detect an amount of applied force to the hybrid sensor 100. As used herein, "proximity" may refer to a threshold distance from the hybrid sensor 100, which may be predefined and/or tunable during manufacturing of the hybrid sensor 100. For example, the threshold distance may be one inch or less, such that the PMUT layer 102 detects the presence of an object (e.g., a finger) when the object is within one inch of the hybrid sensor 100. However, it will be appreciated that the threshold distance for defining "proximity" may be variable in various implementations of the hybrid sensor 100. For example, it may be beneficial for the hybrid sensor 100 to be more sensitive to the presence of an object (i.e., a greater threshold distance) in certain devices than in others.

Subsequently, the CMOS element 132, the BJT 142, and/or the DMOS element 144 as shown in FIG. 1 (or the CMOS element 132 and/or the DMOS element 144 as shown in FIG. 2) may convert the respective signals received from the PZR sensor 122 and the PMUT layer 102 to digital outputs, which can then be compared (e.g., as part of "processing") to respective thresholds to determine whether the user actually interacted with (i.e., touched) a surface associated with the hybrid sensor 100 (e.g., a "true touch event") or whether an event detected by either of the PZR sensor 122 or the PMUT layer 102 was a "false touch event" (i.e., the user did not actually touch the surface).

This disclosure contemplates that the respective thresholds can be set to any value distinguishing between touch/no touch for each of the PZR sensor 122 and the PMUT layer 102, for example, with a touch event mapping to a digital '1' and a no-touch event mapping to a digital '0.' In this example, if the outputs of both the PZR sensor 122 and the PMUT layer 102 agree (e.g., the output signals of the PZR sensor 122 and the PMUT layer 102 are both converted to digital 'high' signals, or '1s'), then the event may be classified as a true touch event. However, if the outputs of both the PZR sensor 122 and the PMUT layer 102 do not agree (e.g., the output signals of one of the PZR sensor 122 or the PMUT layer 102 is converted to a digital '1' while the output of the other component is a '0'), then the event may be classified as a false touch event.

### Device Manufacturing

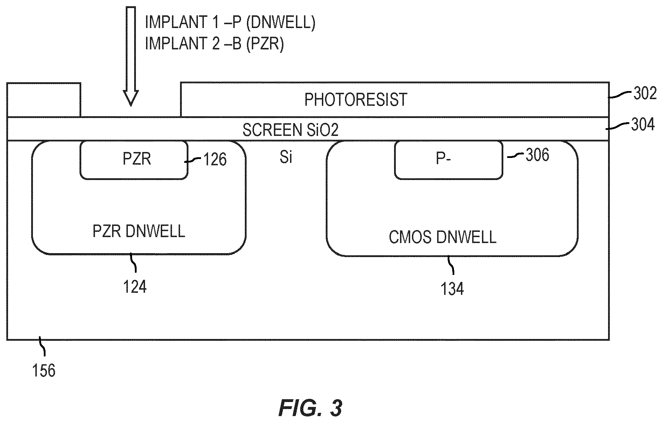

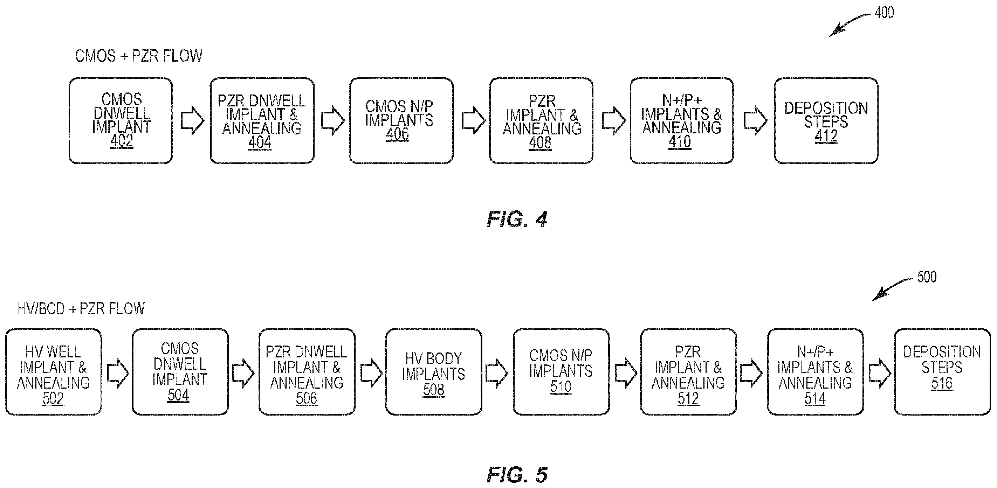

Referring now to FIG. 3, a diagram of a PZR implant process is shown, according to some embodiments. The implant process described herein may be implemented to manufacture at least a portion of the hybrid sensor 100, as described above. For example, the implant process shown in FIG. 3, and further described below with respect to FIGS. 4 and 5, may be used to manufacture at least a portion of the PZR sensor 122 and/or the CMOS element 132. In some embodiments, the CMOS DNWell 134 is first formed using a photoresist mask 302 which exposes a portion of the substrate. Specifically, the CMOS DNWell 134 may be implanted through a screen SiO₂ layer 304 at a first portion of the substrate exposed by the photoresist mask 302 (not shown). Subsequently, the PZR DNWell 124 may be implanted through the screen SiO₂ layer 304 at a second portion of the substrate exposed by the photoresist mask 302, as shown in FIG. 3.

In some embodiments, once both the CMOS DNWell 134 and the PZR DNWell 124 are implanted, various oxide layer deposition and thermal annealing steps are performed. In some such embodiments, a CMOS PWell 306 and the PZR element 126 are then implanted. Specifically, the CMOS PWell 306 can be implanted through a first portion of an oxide layer that is exposed through the photoresist mask 302 (not shown). The PZR element 126 may be implanted a second exposed area of the photoresist mask 302 and into the already defined PZR DNWell 124. In some embodiments, additional layers are implanted to form CMOS devices (e.g., the CMOS element 132), deposit oxide/nitride layers, and create electrical connections using poly-Si or metal (e.g., Al), such as the various electrical connections and traces shown in FIGS. 1 and 2. It is important to note that each downstream deposition process (e.g., after the processes shown in FIG. 3) in which the device (e.g., the hybrid sensor 100) experiences significantly high temperatures (e.g., > 400°C) for an extended period of time can affect the finished doping profile of the PZR element 126 and the PZR DNWell 124. Accordingly, the thermal budget must be carefully considered when formulating implant recipes for the PZR element 126 and the PZR DNWell 124.

Referring now to FIG. 4, a diagram illustrating an example CMOS process 400 is shown, according to some embodiments. In some embodiments, the CMOS process 400 is at least a portion of a manufacturing process for force and/or hybrid force sensor. Accordingly, the CMOS process 400 may include various steps illustrated in FIG. 3 and described above. For example, at step 402, a CMOS DNWell (e.g., the CMOS DNWell 134) may be implanted into a substrate (e.g., the Si layer 156). At step 404, a PZR DNWell (e.g., the PZR DNWell 124) may be implanted into the substrate (e.g., the Si layer 156) and, subsequently, the CMOS DNWell and PZR DNWell are annealed. At step 406, CMOS N and P regions are implanted (e.g., into the CMOS DNWell). At step 408, a PZR (e.g., the PZR element 126) is implanted (e.g., into the PZR DNWell) and is annealed. At step 410, N+ and P+ regions are implanted and annealed. Finally, at step 412, various additional deposition steps are performed.

Referring now to FIG. 5, a diagram illustrating an example HV/BDC process 500 is shown, according to some embodiments. In many respects, the process 500 is similar to the process 400, as described above. For example, steps 504, 506, 510, 512, 514, and 516 of process 500 may be similar to or the same as steps 402-412 of process 400. Thus, for the sake of conciseness, steps 504, 506, 510, 512, 514, and 516 are not repeated. However, unlike a device manufactured using the process 400, which does not include HV or BCD process layers, the process 500 may be implemented to manufacture a device (e.g., the hybrid sensor 100) that does include HV and/or BCD process layers (e.g., the BCD process layer 120 and/or the HV process layer 160).

In this regard, the process 500 includes additional steps for implanting elements both before and after the CMOS/PZR implant stages (e.g., steps 504 and 506) to create these HV/BCD process layers. For example, at step 502, an HV Well is implanted and annealed. At step 508, after the CMOS DNWell and PZR DNWell are implanted and annealed, an HV body may be implanted. In other words, these additional steps of the process 500 may be implemented to implant at least the DMOS element 144, as described above with respect to FIG. 1.

It will be appreciated that the exact order steps of the process 500 may vary and that, in some embodiments, the process 500 may include additional or fewer steps than what is shown in FIG. 5. For example, the order of implanting various elements and/or the order of the thermal annealing stages shown in the process 500 can vary depending on the specific base HV/BCD process used. However, the process 500 generally includes additional steps over a more traditional CMOS process, such as the process 400. Thus, it is important to note that the thermal budget of the hybrid sensor formed using the process 500 may require different implant recipes (e.g., for the CMOS DNWell, PZR DNWell, etc.) to produce a similar doping profile as a device manufactured using the process 400.

### Sensor Packaging

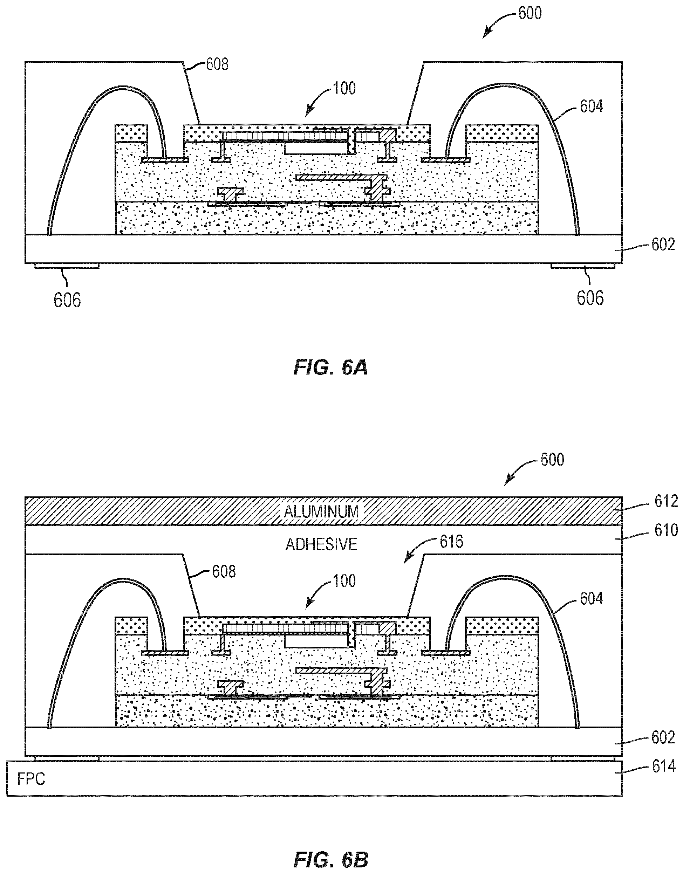

Referring generally to FIGS. 6A-9C, various packaging formats (i.e., implementations) of hybrid sensor 100 are shown. It should first be noted, however, that the hybrid sensor 100 is not limited to the various packaging forms described below; rather, these types of packaging are provided as examples and various other packaging/implementations are contemplated herein. Turning first to FIGS. 6A and 6B, diagrams illustrating a configuration of the hybrid sensor 100 in an open cavity molded package 600 are shown, according to some embodiments. As shown, the hybrid sensor 100 is positioned in a molded package and is disposed atop a frame substrate 602, which may be a laminate frame substrate, a lead frame substrate, or any other type of substrate.

In some embodiments, the hybrid sensor 100 is electrically coupled to a frame substrate 602, also referred to as laminate substrate 602, via one or more bonding wires 604, which may be formed of aluminum, gold, or any other suitable and electrically conductive material (e.g., copper). As shown, the bonding wires 604 may extend from several contacts on the top side of the hybrid sensor 100 to the frame substrate 602. In some embodiments, the hybrid sensor 100 is also encapsulated in a molding compound 608. As described herein, the molding compound 608 may be formed of any material or combination of materials for helping to secure hybrid sensor 100 to frame substrate 602 and is generally not electrically conductive so as to not affect the operation of the hybrid sensor 100 and/or the transmission of electrical signals on the bonding wires 604. Thus, any suitable molding compound is contemplated herein.

In some embodiments, rather than electrically coupling the hybrid sensor 100 to the frame substrate 602, the bonding wires 604 can electrically couple the hybrid sensor 100 directly to one or more contacts 606. Alternatively, the bonding wires 604 can electrically couple the hybrid sensor 100 to the contacts 606 via a printed circuit board (PCB) or a flexible printed circuit (FPC) 614. For example, the FPC 614 may include various electrical traces (not shown) to which the hybrid sensor 100 may be electrically coupled. The contacts 606 may be formed of solder, copper, aluminum, or any other electrically conductive material. As shown, the contacts 606 may be cylindrical in shape but may also be of any other shape. For example, in some embodiments, the contacts 606 may be balls of solder positioned on a bottom side of frame substrate 602. In some embodiments, the electrical contacts 606 may electrically and/or mechanically couple the hybrid sensor 100 to the FPC 614.

As also shown in FIG. 6B, in some embodiments, a cavity 616 may be formed in molding compound 608. In particular, the cavity 616 may be centered over the portion of the hybrid sensor 100 including the PMUT layer 102 to allow for the transmission and reception (e.g., by the PMUT layer 102) of ultrasonic pressure waves. In some embodiments, the cavity 616 may be filled with a medium that aids in the transmission of ultrasonic pressure waves. In FIG. 6B, for example, the cavity 616 is filled with an adhesive 610. Accordingly, the adhesive 610 may be any suitable material that allows the propagation of ultrasonic pressure waves. In some embodiments, the adhesive 610 extends beyond the edges of the cavity 610 and covers a portion of the molding compound 608. The adhesive 610 may also bond the hybrid sensor 100, the frame substrate 602, and/or the molding compound 608 to a touch surface 612. While shown as an aluminum surface in FIG. 6B, it will be appreciated that the touch surface 612 may be any surface that a user may interact with, such as a glass or plastic surface.

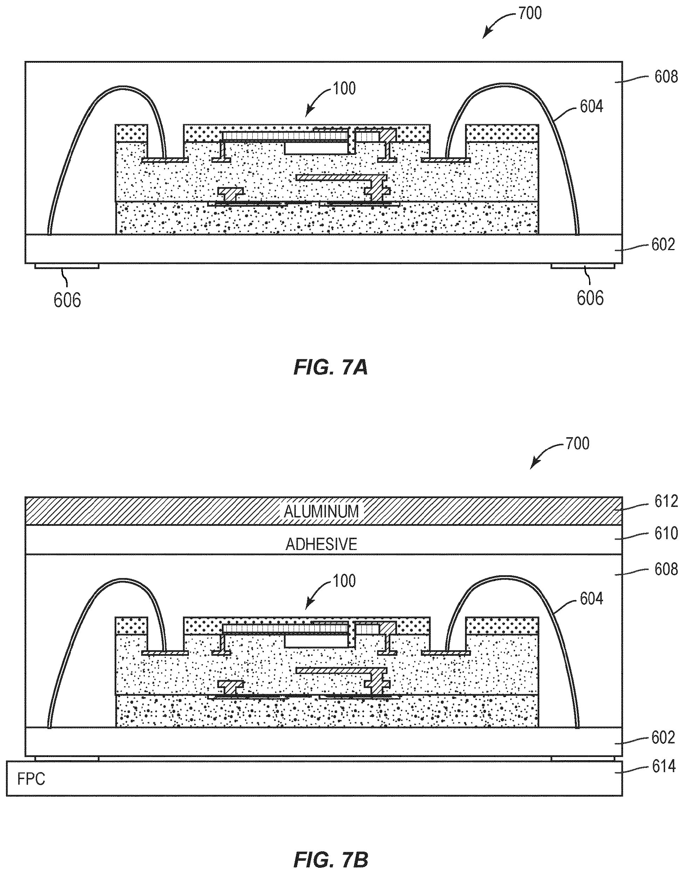

Referring now to FIGS. 7A and 7B, diagrams illustrating an alternate configuration of the hybrid sensor 100 in an open-cavity molded package 700 are shown, according to some embodiments. In many ways, the alternate configuration of the hybrid sensor 100 shown in FIGS. 7A and 7B is similar to the configuration shown in FIGS. 6A and 6B. For example, both configurations show that the hybrid sensor 100 is positioned on the frame substrate 602 and is electrically coupled to the frame substrate 602 and/or the contacts 606 via the bonding wires 604. Additionally, the hybrid sensor 100 is shown to be encapsulated in the molding compound 608. However, unlike the configuration shown in FIGS. 6A and 6B, the open-cavity molded package 700 does not include a cavity formed into molding compound 608 (e.g., the cavity 616).

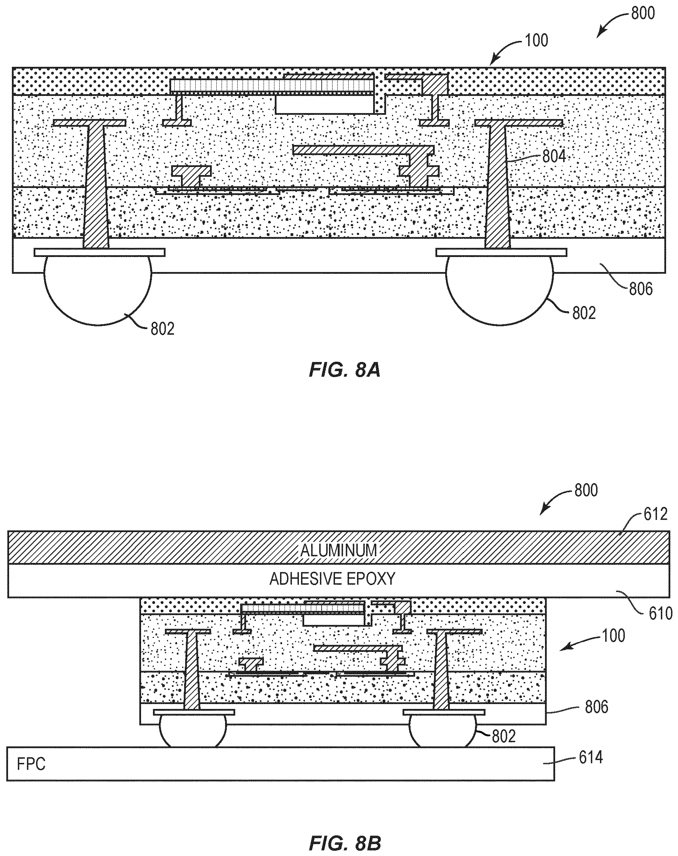

Referring now to FIGS. 8A and 8B, diagrams illustrating a configuration of the hybrid sensor 100 in a back-side wafer-level chip-scale package (WLCSP) 800 are shown, according to some embodiments. As shown, in this configuration, the hybrid sensor 100 may include one or more contacts 802 positioned on a bottom side of the device, opposite of the PMUT layer 102. The contacts 802 may be any suitable, electrically conductive material that can electrically and/or mechanically couple the hybrid sensor 100 to FPC 614. For example, in FIG. 8A, the contacts 802 are illustrated as balls of solder. In some embodiments, the hybrid sensor 100 is electrically coupled to the contacts 802 via one or more through-silicon via (TSV) connections 804, which extend from contacts positioned on a top side of the hybrid sensor 100 to the bottom side of the hybrid sensor 100. In some embodiments, the TSV connections 804 extend through an insulating layer 806, which may be formed of polyimide or any other suitable material. In some embodiments, the WLSCP 800 further includes a metal redistribution layer (RDL) positioned over the insulating later 806, which allows the contacts 802 to be at different positions than the TSV connections 804. For example, the TSV connections 804 may electrically couple the hybrid sensor 100 to an RDL, and the contacts 802 may be electrically coupled to the RDL at various positions.

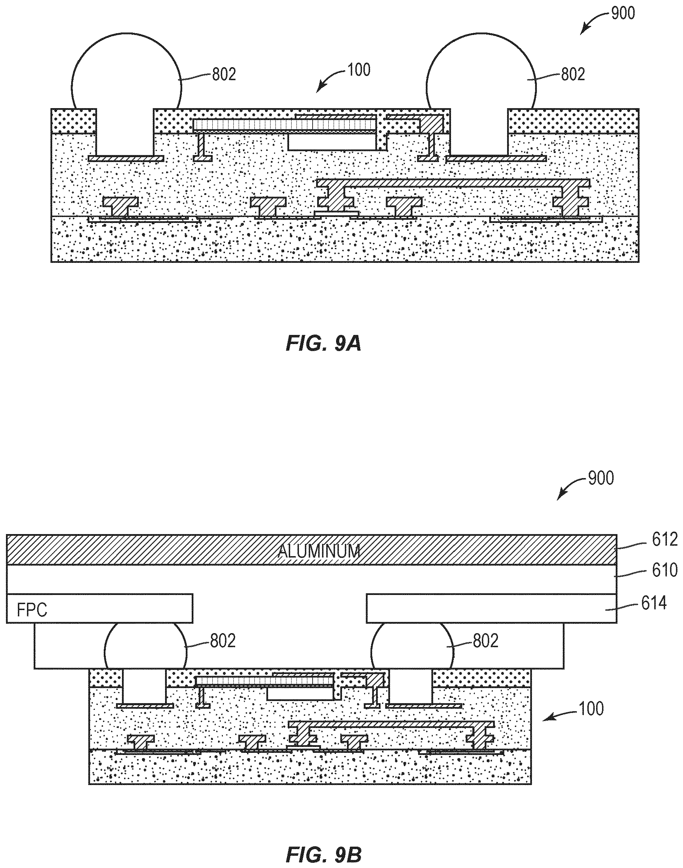

Referring now to FIGS. 9A-9C, diagrams illustrating a configuration of the hybrid sensor 100 in a standard WLSCP 900 are shown, according to some embodiments. In some respects, the configuration of the WLSCP 900 is similar to the configuration of the WLSCP 900; however, in the configuration shown in FIGS. 9A-9C, the contacts 802 are positioned on a top side of the hybrid sensor 100 (e.g., on the same side as the PMUT layer 102). As shown, for example, the contacts 802 extend directly from the top contacts of the hybrid sensor 100 to electrically and/or mechanically couple the hybrid sensor 100 to the FPC 614. In some other embodiments, an insulating layer and/or an RDL may be positioned over the hybrid sensor 100 to allow for the contacts 802 to be electrically connected to the hybrid sensor 100 via the RDL. In some such embodiments, the RDL may be positioned over the insulating layer.

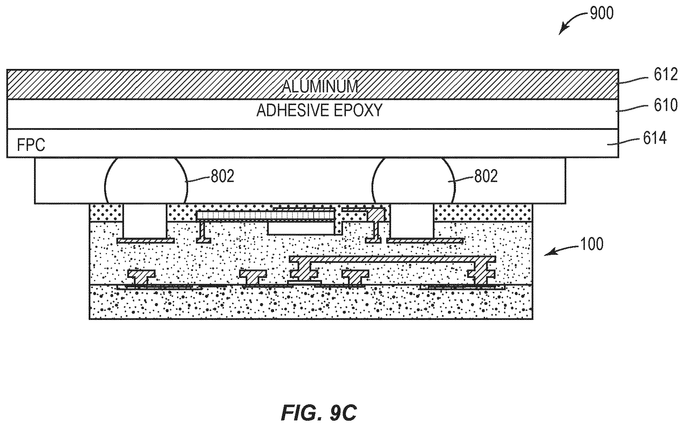

In some embodiments, the adhesive 610 is disposed over the top of the hybrid sensor 100 and/or the FPC 614 for mechanically coupling the hybrid sensor 100 and/or the FPC 614 to the touch surface 612. In some embodiments, an acoustic window 906? may be formed in the FPC 614 to allow for the propagation of ultrasonic pressure waves (e.g., transmitted and received by PMUT layer 102) from/to the hybrid sensor 100. As shown, in some embodiments, the acoustic window 906? is filled with the adhesive 610, which may be any material that aids in the transmission of ultrasonic pressure waves. As shown in FIG. 9C, however, the acoustic window 906? is not formed in FPC 614 in certain embodiments.

### Configuration of Example Embodiments

Therefore, from one perspective, there has been described that a hybrid sensor can includes a piezoresistive element for sensing an applied force, a piezoelectric micromachined ultrasonic transducer (PMUT) for sensing the presence of an object within a threshold distance of the hybrid sensor, and a substrate onto which both the piezoresistive element and the PMUT are disposed.

The construction and arrangement of the systems and methods as shown in the various example embodiments are illustrative only. Although only a few embodiments have been described in detail in this disclosure, many modifications are possible (e.g., variations in sizes, dimensions, structures, shapes and proportions of the various elements, values of parameters, mounting arrangements, use of materials, colors, orientations, etc.) without departing from the scope of the claims. For example, the position of elements may be reversed or otherwise varied, and the nature or number of discrete elements or positions may be altered or varied. The order or sequence of any process or method steps may be varied or re-sequenced according to alternative embodiments. Other substitutions, modifications, changes, and omissions may be made in the design, operating conditions, and arrangement of the example embodiments without departing from the scope of the claims. It is to be understood that the methods and systems are not limited to specific synthetic methods, specific components, or to particular compositions. It is also to be understood that the terminology used herein is for the purpose of describing particular embodiments only and is not intended to be limiting.

As used in the specification and the appended claims, the singular forms "a," "an" and "the" include plural referents unless the context clearly dictates otherwise. Ranges may be expressed herein as from "about" one particular value, and/or to "about" another particular value. When such a range is expressed, another embodiment includes¬ from the one particular value and/or to the other particular value. Similarly, when values are expressed as approximations, by use of the antecedent "about," it will be understood that the particular value forms another embodiment. It will be further understood that the endpoints of each of the ranges are significant both in relation to the other endpoint, and independent of the other endpoint.

"Optional" or "optionally" means that the subsequently described event or circumstance may or may not occur, and that the description includes instances where said event or circumstance occurs and instances where it does not. Throughout the description and claims of this specification, the word "comprise" and variations of the word, such as "comprising" and "comprises," means "including but not limited to," and is not intended to exclude, for example, other additives, components, integers or steps. "Exemplary" means "an example of" and is not intended to convey an indication of a preferred or ideal embodiment. "Such as" is not used in a restrictive sense, but for explanatory purposes.

Disclosed are components that can be used to perform the disclosed methods and systems. These and other components are disclosed herein, and it is understood that when combinations, subsets, interactions, groups, etc., of these components are disclosed that while specific reference of each various individual and collective combinations and permutation of these may not be explicitly disclosed, each is specifically contemplated and described herein, for all methods and systems. This applies to all aspects of this application including, but not limited to, steps in disclosed methods. Thus, if there are a variety of additional steps that can be performed it is understood that each of these additional steps can be performed with any specific embodiment or combination of embodiments of the disclosed methods, wherein the scope of protection is defined by the claims.

## Claims

1. A hybrid sensor (100) comprising:
a piezoresistive element (122) for sensing an applied force;
a piezoelectric micromachined ultrasonic transducer (102), PMUT, for sensing the presence of an object within a threshold distance of the hybrid sensor; **characterized in that** the hybrid sensor further comprises
a substrate (156) onto which both the piezoresistive element and the PMUT are disposed,
wherein the piezoresistive element is implanted into a surface of the substrate, and wherein the PMUT is layered over the surface of the substrate.

2. The hybrid sensor of claim 1, wherein the PMUT is configured to transmit and receive ultrasonic pressure waves to sense the presence of the object, for example wherein the ultrasonic pressure waves are in the range of 100 kHz to 100 MHz.

3. The hybrid sensor of claim 1 or 2, wherein the PMUT comprises a piezoelectric layer disposed between a bottom electrode (110) and a top electrode (114), and a resonator cavity (112) disposed below the bottom electrode.

4. The hybrid sensor of claim 3, wherein the resonator cavity is a sealed cavity.

5. The hybrid sensor of claim 3 or 4 wherein the piezoelectric layer is made of aluminum nitride, AlN, or scandium-doped aluminum nitride, AlScN.

6. The hybrid sensor of claim 3, 4 or 5, wherein the bottom electrode comprises molybdenum, Mo.

7. The hybrid sensor of any preceding claim, further comprising a processing circuitry configured to process respective electrical signals output from each of the piezoresistive element and the PMUT, for example wherein the processing circuity is disposed on the substrate.

8. The hybrid sensor of claim 7, wherein the respective electrical signal output from the piezoresistive element is responsive to the applied force.

9. The hybrid sensor of claim 7 or 8, wherein the respective electrical signal output from the PMUT is responsive to the presence of the object within the threshold distance of the hybrid sensor.

10. The hybrid sensor of claim 7, 8 or 9, wherein the processing circuitry is configured to process the respective electrical signals by comparing the respective electrical signals to respective thresholds to determine whether a touch event is classified as a true touch event or a false touch event, for example wherein the touch event is classified as the true touch event when each of the respective electrical signals exceeds the respective threshold, and the touch event is classified as the false touch event when only one of the respective electrical signals exceeds the respective threshold.

11. The hybrid sensor of any of claims 7 to 10, wherein the processing circuitry includes at least one of a complementary metal-oxide-semiconductor (132), CMOS, a double-diffused metal-oxide semiconductor field-effect transistor (144), DMOS, or a bi-polar junction transistor (142), BJT.

12. The hybrid sensor of any of claims 7 to 11, wherein the processing circuitry is further configured to apply a plurality of high-voltage pulses to the PMUT to cause the PMUT to transmit ultrasonic pressure waves.

13. The hybrid sensor of any preceding claim, wherein the hybrid sensor is implemented in an open-cavity molded package, for example wherein the open-cavity molded package includes a cavity (616) disposed on top of the PMUT, the cavity filled with a medium that transmits ultrasonic pressure waves to the PMUT.

14. The hybrid sensor of any preceding claim, wherein the hybrid sensor is implemented in one selected from the group comprising: a back-side wafer level chip scale package, WLCSP; and a standard wafer level chip scale package, WLCSP.

## Patentansprüche

1. Hybridsensor (100), umfassend:
ein piezoresistives Element (122) zum Abfühlen einer angelegten Kraft;
einen piezoelektrischen mikrobearbeiteten Ultraschallwandler (102), PMUT, zum Abfühlen der Anwesenheit eines Objekts innerhalb eines Schwellenabstands des Hybridsensors; **dadurch gekennzeichnet, dass** der Hybridsensor ferner umfasst:
ein Substrat (156), auf dem sowohl das piezoresistive Element als auch der PMUT angeordnet sind,
wobei das piezoresistive Element in eine Oberfläche des Substrats implantiert ist, und wobei der PMUT über die Oberfläche des Substrats geschichtet ist.

2. Hybridsensor nach Anspruch 1, wobei der PMUT dazu ausgelegt ist, Ultraschalldruckwellen zu senden und zu empfangen, um die Anwesenheit des Objekts abzufühlen, wobei zum Beispiel die Ultraschalldruckwellen im Bereich von 100 kHz bis 100 MHz liegen.

3. Hybridsensor nach Anspruch 1 oder 2, wobei der PMUT eine piezoelektrische Schicht, die zwischen einer unteren Elektrode (110) und einer oberen Elektrode (114) angeordnet ist, und einen Resonatorhohlraum (112), der unterhalb der unteren Elektrode angeordnet ist, umfasst.

4. Hybridsensor nach Anspruch 3, wobei der Resonatorhohlraum ein versiegelter Hohlraum ist.

5. Hybridsensor nach Anspruch 3 oder 4, wobei die piezoelektrische Schicht aus Aluminiumnitrid, AlN oder scandiumdotiertem Aluminiumnitrid, AlScN, hergestellt ist.

6. Hybridsensor nach Anspruch 3, 4 oder 5, wobei die untere Elektrode Molybdän, Mo, umfasst.

7. Hybridsensor nach einem der vorhergehenden Ansprüche, ferner umfassend eine Verarbeitungsschaltungsanordnung, die dazu ausgelegt ist, jeweilige elektrische Signale zu verarbeiten, die von jedem von dem piezoresistiven Element und dem PMUT ausgegeben werden, wobei zum Beispiel die Verarbeitungsschaltungsanordnung auf dem Substrat angeordnet ist.

8. Hybridsensor nach Anspruch 7, wobei das jeweilige elektrische Signal, das von dem piezoresistiven Element ausgegeben wird, auf die angelegte Kraft anspricht.

9. Hybridsensor nach Anspruch 7 oder 8, wobei das jeweilige elektrische Signal, das von dem PMUT ausgegeben wird, auf die Anwesenheit des Objekts innerhalb des Schwellenabstands des Hybridsensors anspricht.

10. Hybridsensor nach Anspruch 7, 8 oder 9, wobei die Verarbeitungsschaltungsanordnung dazu ausgelegt ist, die jeweiligen elektrischen Signale durch Vergleichen der jeweiligen elektrischen Signale mit jeweiligen Schwellenwerten zu verarbeiten, um zu bestimmen, ob ein Berührungsereignis als ein wahres Berührungsereignis oder ein falsches Berührungsereignis klassifiziert wird, wobei zum Beispiel das Berührungsereignis als das wahre Berührungsereignis klassifiziert wird, wenn jedes der jeweiligen elektrischen Signale den jeweiligen Schwellenwert überschreitet, und das Berührungsereignis als das falsche Berührungsereignis klassifiziert wird, wenn nur eines der jeweiligen elektrischen Signale den jeweiligen Schwellenwert überschreitet.

11. Hybridsensor nach einem der Ansprüche 7 bis 10, wobei die Verarbeitungsschaltungsanordnung mindestens einen von einem komplementären Metalloxidhalbleiter (132), CMOS, einem doppeldiffundierten Metalloxidhalbleiter-Feldeffekttransistor (144), DMOS, oder einem bipolaren Sperrschichttransistor (142), BJT, einschließt.

12. Hybridsensor nach einem der Ansprüche 7 bis 11, wobei die Verarbeitungsschaltungsanordnung ferner dazu ausgelegt ist, eine Vielzahl von Hochspannungsimpulsen an den PMUT anzulegen, um zu bewirken, dass der PMUT Ultraschalldruckwellen überträgt.

13. Hybridsensor nach einem der vorhergehenden Ansprüche, wobei der Hybridsensor in einem geformten Gehäuse mit offenem Hohlraum implementiert ist, wobei zum Beispiel das geformte Gehäuse mit offenem Hohlraum einen Hohlraum (616) einschließt, der auf dem PMUT angeordnet ist, wobei der Hohlraum mit einem Medium gefüllt ist, das Ultraschalldruckwellen an den PMUT überträgt.

14. Hybridsensor nach einem der vorhergehenden Ansprüche, wobei der Hybridsensor in einem ausgewählt aus der Gruppe implementiert ist, die ein Rückseiten-Waferebenen-Chip Scale Package, WLCSP; und ein Standard-Waferebenen-Chip Scale Package, WLCSP, umfasst.

## Revendications

1. Capteur hybride (100) comprenant :
un élément piézorésistif (122) destiné à détecter une force appliquée ;
un transducteur ultrasonore piézoélectrique micro-usiné (102), PMUT, destiné à détecter la présence d'un objet à moins d'une distance seuil du capteur hybride ;
**caractérisé en ce que** le capteur hybride comprend en outre
un substrat (156) sur lequel sont disposés à la fois l'élément piézorésistif et le PMUT,
dans lequel l'élément piézorésistif est implanté à l'intérieur d'une surface du substrat, et dans lequel le PMUT est déposé en couche au-dessus de la surface du substrat.

2. Capteur hybride selon la revendication 1, dans lequel le PMUT est conçu pour émettre et recevoir des ondes de pression ultrasonores pour détecter la présence de l'objet, par exemple dans lequel les ondes de pression ultrasonores se situent dans une plage de 100 kHz à 100 MHz.

3. Capteur hybride selon la revendication 1 ou 2, dans lequel le PMUT comprend une couche piézoélectrique disposée entre une électrode inférieure (110) et une électrode supérieure (114), et une cavité de résonateur (112) disposée sous l'électrode inférieure.

4. Capteur hybride selon la revendication 3, dans lequel la cavité de résonateur est une cavité scellée.

5. Capteur hybride selon la revendication 3 ou 4 dans lequel la couche piézoélectrique est constituée de nitrure d'aluminium, AlN, ou de nitrure d'aluminium dopé au scandium, AlScN.

6. Capteur hybride selon la revendication 3, 4 ou 5, dans lequel l'électrode inférieure comprend du molybdène, Mo.

7. Capteur hybride selon une quelconque revendication précédente, comprenant en outre des circuits de traitement conçus pour traiter des signaux électriques respectifs délivrés à la fois depuis l'élément piézorésistif et depuis le PMUT, par exemple dans lequel les circuits de traitement sont disposés sur le substrat.

8. Capteur hybride selon la revendication 7, dans lequel le signal électrique respectif délivré depuis l'élément piézorésistif est sensible à la force appliquée.

9. Capteur hybride selon la revendication 7 ou 8, dans lequel le signal électrique respectif délivré depuis le PMUT est sensible à la présence de l'objet à moins de la distance seuil du capteur hybride.

10. Capteur hybride selon la revendication 7, 8 ou 9, dans lequel les circuits de traitement sont conçus pour traiter les signaux électriques respectifs en comparant les signaux électriques respectifs à des seuils respectifs pour déterminer si un évènement tactile est classé comme un évènement tactile réel ou un faux évènement tactile, par exemple dans lequel l'évènement tactile est classé comme l'évènement tactile réel quand chacun des signaux électriques respectifs dépasse le seuil respectif, et l'évènement tactile est classé comme le faux évènement tactile quand un seul des signaux électriques respectifs dépasse le seuil respectif.

11. Capteur hybride selon l'une quelconque des revendications 7 à 10, dans lequel les circuits de traitement comportent au moins un élément parmi un semiconducteur à oxyde métallique complémentaire (132), CMOS, un transistor à effet de champ métal-oxyde-semiconducteur à double diffusion (144), DMOS, et un transistor à jonction bipolaire (142), BJT.

12. Capteur hybride selon l'une quelconque des revendications 7 à 11, dans lequel les circuits de traitement sont également conçus pour appliquer une pluralité d'impulsions à haute tension au PMUT pour amener le PMUT à émettre des ondes de pression ultrasonores.

13. Capteur hybride selon une quelconque revendication précédente, le capteur hybride étant mis en œuvre dans un boîtier moulé à cavité ouverte, par exemple dans lequel le boîtier moulé à cavité ouverte comporte une cavité (616) disposée au-dessus du PMUT, la cavité étant remplie avec un milieu qui transmet les ondes de pression ultrasonores au PMUT.

14. Capteur hybride selon une quelconque revendication précédente, le capteur hybride étant mis en œuvre dans un élément choisi dans le groupe comprenant : un boîtier à puce sur tranche côté arrière, WLCSP ; et un boîtier à puce sur tranche standard, WLCSP.
